# DEMANDE DE BREVET EUROPEEN

(11) **EP 0 601 926 A1**
(43) Date de publication de la demande: **15.06.1994**
(21) Numéro de dépôt: 93402953.9
(22) Date de dépôt: 07.12.1993
(51) Int. Cl.: G01R 21/10

(54) **Dispositif de détection de puissance sur la sortie d'un circuit électronique**

(30) Priorité: 11.12.1992 FR 9214950
(71) Demandeur: THOMSON-CSF SEMICONDUCTEURS SPECIFIQUES, 75008 Paris (FR)
(72) Inventeur: Pataut, Gérard, THOMSON-CSF, F-92402 Courbevoie Cedex (FR); Dietsche, Stéfan, THOMSON-CSF, F-92402 Courbevoie Cedex (FR)
(74) Mandataire: Guérin, Michel

(57) **Abrégé**

L'invention concerne l'asservissement d'un circuit électronique, qui nécessite la détection de la puissance délivrée sur sa sortie.

Ce dispositif est essentiellement constitué par un transistor (13) à effet de champ, à polarisation V_{DS} nulle, monté entre la masse et un réseau d'adaptation (11,12) en sortie du circuit. Ce transistor se comporte soit comme une capacité, soit comme une diode. Un filtre passe-bas (14,15,16), connecté entre le transistor (13) et le réseau (11,12), délivre une tension de détection (V_{dét})

Application aux circuits hyperfréquences.

## Description

La présente invention concerne un dispositif de détection de puissance sur la sortie d'un circuit électronique tel qu'un amplificateur de puissance comportant au moins un transistor à effet de champ et un réseau d'adaptation en sortie.

Par réseau d'adaptation en sortie, on entend un réseau destiné améliorer ou adapter une caractéristique électrique du circuit. Ce peut être un réseau d'adaptation d'impédance, par exemple, ou un réseau de réjection d'harmonique, dans un générateur de fréquence, ou à la sortie d'un amplificateur pour lequel une norme impose par exemple qu'il court-circuite l'harmonique 2 et qu'il soit en circuit ouvert à l'harmonique 3 (classe F). De façon plus générale, il est bien rare qu'un circuit électronique ne comporte pas en sortie un réseau, essentiellement composé de résistances, selfs, et capacités, pour l'adapter à une spécification.

Le dispositif selon l'invention a été étudié pour des applications dans le domaine des microondes (1 à plusieurs dizaines de GHZ) mais il est également applicable à des circuits fonctionnant à de plus basses fréquences.

Ce dispositif a pour objet la détection d'une puissance électrique présente sur une borne de sortie d'un circuit : le signal de détection peut servir à activer une fonction électrique qui était auparavant en sommeil, ou à asservir l'alimentation d'un transistor, ou encore à assumer un signal d'alerte, par exemple.

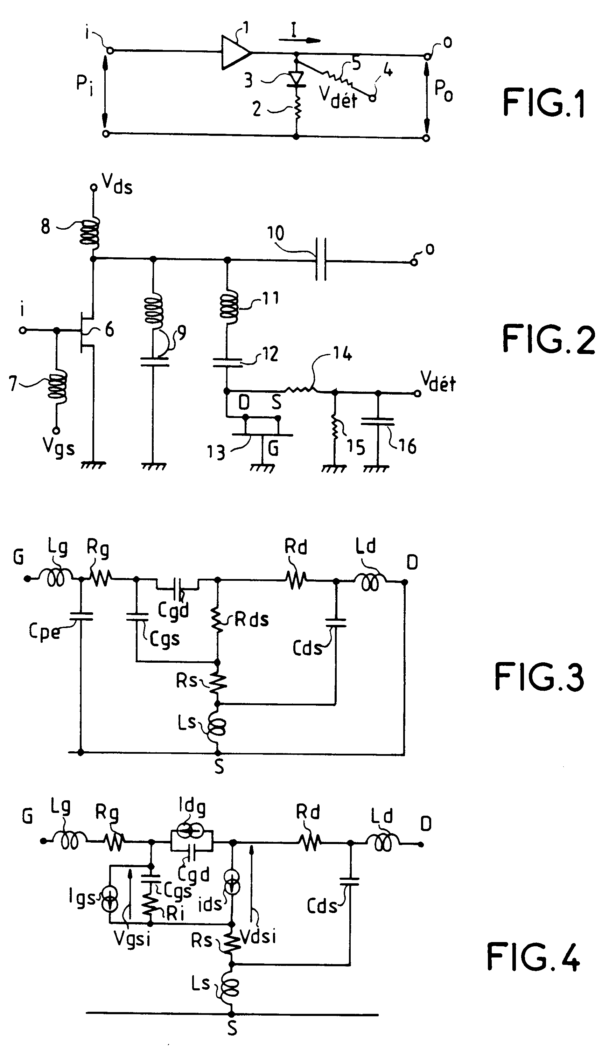

La fonction de détection de puissance est en soi bien connue, et son application est très courante dans les alimentations stabilisées, en courant ou en tension. Le principe en est donné en figure 1. Dans un montage comportant un circuit électronique 1, tel qu'un amplificateur, susceptible de moduler le courant débité entre les bornes d'entrée "i" et les bornes de sortie "o", ce courant I est détecté par la tension qui se crée aux bornes d'une résistance 2 de haute valeur. La tension de détection V_{dét.} du courant I est en fait prise à l'anode d'une diode 3. Une résistance 5, de valeur élevée, sur la sortie de détection adapte l'impédance, pour l'appareil de mesure.

Dans le dispositif selon l'invention, la détection de puissance se fait au moyen d'un transistor à effet de champ, qui est intégré à un réseau d'adaptation, comportant au moins une self et une capacité. Ce transistor répond à une double spécification : sa grille est à la masse, et il n'est pas polarisé, de sorte qu'il se comporte soit comme une capacité soit comme une diode selon qu'il détecte ou non un courant dans le circuit. Le transistor à effet de champ, par sa capacité équivalente, participe au réseau d'adaptation.

De façon plus précise, l'invention concerne un dispositif de détection de puissance sur la sortie d'un circuit électronique fonctionnant dans le domaine des microondes, et comportant entre sa sortie (o) et la masse un réseau d'adaptation (11+12), ce dispositif de détection de la puissance en sortie étant caractérisé en ce qu'il est incorporé au réseau d'adaptation (11+12), et monté entre le dit réseau et la masse.

L'invention sera mieux comprise par la description qui est faite maintenant d'un exemple d'application, avec référence aux figures jointes en annexe, qui représentent :
- figure 1 : schéma de principe de la détection de puissance, selon l'art connu,
- figure 2 : schéma du dispositif de détection de puissance selon l'invention,
- figure 3 : schéma électrique équivalent d'un transistor non-polarisé,
- figure 4 : schéma électrique non-linéaire d'un transistor à effet de champ.

Le dispositif selon l'invention est applicable à n'importe quel circuit dans lequel circule une certaine puissance électrique. Cependant, afin de rendre plus clair l'énoncé de l'invention, celui-ci s'appuiera sur l'exemple déjà cité d'un amplificateur fonctionnant selon des spécifications précises, par exemple la classe F, qui lui imposent d'être muni en sortie d'un filtre de réjection de fréquence.

La figure 2 représente un tel amplificateur, que l'on peut simplifier et en ramener le schéma à un transistor à effet de champ 6. L'entrée d'un signal se fait sur sa grille, en "i", et le signal amplifié est recueilli sur la sortie "o", éventuellement à travers une capacité de couplage 10, sur le drain du transistor. Les circuits de découplage des tensions de polarisation de grille V_{gs}et de drain V_{ds} sont représentés par leurs selfs 7 et 8, et un circuit auxiliaire tel que 9 peut servir de filtre de fréquence, ou d'adaptation d'impédance.

De façon à répondre aux spécifications, qui lui sont imposées, cet amplificateur comporte également sur sa sortie, un réseau de réjection d'harmonique, qui comprend au moins une self 11 et une capacité 12. Normalement, en dehors de l'invention, ce réseau est mis à la masse, et il permet de régler le couplage à la fréquence fondamentale et de choisir les harmoniques d'ordre supérieur ou égal à 2 qui sont présentés en sortie de l'amplificateur : par exemple, il court-circuite l'harmonique 2 mais il est en circuit ouvert à l'harmonique 3.

Mais selon l'invention, ce réseau de réjection d'harmonique 11 + 12 est monté en série avec un transistor à effet de champ 13, dont la grille G est à la masse, et dont la source S et le drain D sont court- circuités : ce transistor 13 est donc à tension de polarisation drain-source nulle, et il est non polarisé.

La détection de la puissance débitée sur la sortie "o" de l'amplificateur se fait au moyen d'un filtre passe-bas composé des résistances 14 et 15 et de la capacité 16. Ce filtre passe-bas est connecté sur le réseau de réjection, entre la capacité 12 et le transistor 13, et il délivre sur sa sortie un signal V_{dét.} de détection d'une puissance sur la sortie "o" de l'amplificateur.

Par rapport à une harmonique , filtrée par le réseau de réjection, le transistor à effet de champ 13 polarisé à tension drain-source nulle V_{ds} = 0 se comporte essentiellement comme une capacité, ainsi que le montre la figure 3, qui représente le schéma électrique d'un transistor dit "froid", c'est à dire dans lequel V_{ds} = 0 parce que les électrodes de source et drain sont court-circuitées. Le schéma équivalent d'un tel transistor est essentiellement une capacité C_{gs} en parallèle avec C_{gd}, à laquelle il convient d'ajouter la capacité parasite d'entrée Cₚₑpour compléter le schéma équivalent. Ainsi, le réseau de réjection à la fréquence harmonique, pour une harmonique d'ordre n>2, est constitué par l'inductance 11 et la capacité équivalente C_{eq} égale à la somme de la capacité 12 et de la capacité du transistor "froid" 13 (C_{gs} + C_{gd} + Cₚₑ).

Pour un signal à la fréquence fondamentale, non filtré par le réseau de réjection 11 + 12, il faut considérer pour le transistor 13 le schéma non-linéaire donné en figure 4.

Une très faible partie du signal à fréquence fondamentale passe par le filtre de réjection 11 + 12 et cette faible amplitude de signal à la fréquence fondamentale appliquée sur le transistor 13 est suffisante pour fournir un courant proportionnel à la puissance délivrée sur la sortie "o". Ce courant de détection est représenté sur la figure 4 par la somme des courants I_{dg}, I_{gs}, qui n'existaient pas dans le schéma équivalent de la figure 3. Ce sont essentiellement I_{dg} et I_{gs} qui fournissent le courant de détection de puissance, transformé par le réseau de résistances 14 et 15 en une tension V_{det} proportionnelle à la puissance existant sur la sortie "o".

Le réseau de réjection 11 + 12 permet de contrôler le niveau prélevé sur la fréquence fondamentale et de régler la réjection des harmoniques. Le réseau de détection 14+15+16 est un filtre passe-bas : il n'a pas d'influence en micro-ondes. De même, le transistor détecteur 13 est découplé par rapport à la sortie : il perturbe peu le fonctionnement, et n'induit, en tant que détecteur, qu'une faible perte de puissance disponible sur la sortie "o".

L'invention a été exposée en s'appuyant sur l'exemple d'un amplificateur ayant au moins une harmonique en plus de la fréquence fondamentale. Il est évident pour l'homme de l'art que le même dispositif de détection de puissance peut être appliqué à d'autres fonctions électroniques, telles qu'un mélangeur, un oscillateur ... etc.

Il est également évident que le dispositif de détection selon l'invention, qui est ici incorporé à un réseau de réjection d'harmonique, peut être incorporé à un réseau de filtrage n'ayant pas de rapport harmonique avec la fréquence fondamentale .

Enfin, les composants d'au moins le dispositif de détection ne sont pas nécessairement de type localisé, comme représenté sur les figures. Ce peut être des composants de type distribué.

Le dispositif selon l'invention présente l'avantage d'inclure les deux fonctions de réjection et de détection en un seul réseau, et d'être entièrement compatible avec les étapes de réalisation d'une technologie microonde.

Il présente peu de composants, qui n'entraînent donc que peu de pertes en sortie, et le couplage, réglé par le réseau 11 + 12, du réseau de détection, par rapport à la sortie est faible, ce qui ne perturbe pas le fonctionnement du système contrôlé, amplificateur ou oscillateur.

L'invention est précisée par les revendications suivantes.

## Revendications

**1 -** Dispositif de détection de puissance sur la sortie d'un circuit électronique fonctionnant dans le domaine des microondes, et comportant entre sa sortie (o) et la masse un réseau d'adaptation (11 + 12), ce dispositif de détection de la puissance en sortie étant caractérisé en ce qu'il est incorporé au réseau d'adaptation (11 + 12), et est monté entre le dit réseau et la masse.

**2 -** Dispositif selon la revendication 1, caractérisé en ce que le réseau d'adaptation est un réseau de réjection et en ce qu'il comporte au moins une inductance (11) et une capacité (12).

**3 -** Dispositif selon la revendication 2, caractérisé en ce qu'il comporte :
- en premier lieu un transistor à effet de champ (13), détecteur, à polarisation drain/source nulle, dont la grille est à la masse et dont le drain et la source, court-circuités, sont réunis au réseau d'adaptation (11 + 12)
- et en second lieu un filtre passe-bas (14,15,16), connecté au point commun entre le transistor (13) détecteur et le réseau d'adaptation, ce filtre passe-bas délivrant sur sa sortie une tension de détection (V_{dét}) proportionnelle au courant débité sur électronique. la sortie (o) du circuit électronique.

**4 -** Dispositif selon la revendication 3, caractérisé en ce que les valeurs des composants du réseau d'adaptation (11,12) permettent de régler le couplage du dispositif de détection (13 à 16) avec la sortie (o) du circuit électronique.
